Europäisches Patentamt

European Patent Office

Office européen des brevets

(19)

(11) **EP 0 685 143 B1**

(12)

# FASCICULE DE BREVET EUROPEEN

(45) Date de publication et mention
de la délivrance du brevet:
**10.09.1997 Bulletin 1997/37**

(21) Numéro de dépôt: **94907590.7**

(22) Date de dépôt: **17.02.1994**

(51) Int Cl.6: **H05H 1/18**, H05H 1/46

(86) Numéro de dépôt international:
**PCT/FR94/00179**

**WO 94/19921 (01.09.1994 Gazette 1994/20)**

(54) **SOURCE MICRO-ONDE LINEAIRE POUR LE TRAITEMENT DE SURFACES PAR PLASMA**

LINEARE MIKROWELLENQUELLE ZUR PLASMABEHANDLUNG VON FLÄCHEN.

LINEAR MICROWAVE SOURCE FOR THE PLASMA TREATMENT OF SURFACES

(84) Etats contractants désignés:
**CH DE GB IT LI NL**

(30) Priorité: **18.02.1993 FR 9301847**

(43) Date de publication de la demande:
**06.12.1995 Bulletin 1995/49**

(73) Titulaire: **COMMISSARIAT A L'ENERGIE
ATOMIQUE
75752 Paris Cédex 15 (FR)**

(72) Inventeurs:
• **BRIFFOD, Georges
F-38180 Seyssins (FR)**
• **NGUYEN, Trong, Khoi
F-38120 Saint-Egrève (FR)**

(74) Mandataire: **Poulin, Gérard et al
Société BREVATOME
25, rue de Ponthieu
75008 Paris (FR)**

(56) Documents cités:
**EP-A- 0 252 845          WO-A-92/21136
US-A- 4 767 931**

• **PATENT ABSTRACTS OF JAPAN vol. 11, no. 367
(E-561) 28 Novembre 1987 & JP,A,62 140 339
(HITACHI) 23 Juin 1987**
• **PATENT ABSTRACTS OF JAPAN vol. 12, no. 440
(E-684) 18 Novembre 1988 & JP,A,63 172 429
(ULVAC) 16 Juillet 1988**
• **NUCLEAR FUSION, vol.25, no.4, 1985, VIENNA
AT pages 419 - 423 GORMEZANO ET AL.
'Lower-hybrid plasma heating via a new
launcher - The multijunction grid'**
• **PATENT ABSTRACTS OF JAPAN vol. 14, no. 7
(C-673) 10 Janvier 1989 & JP,A,01 254 245
(ANELVA)**
• **PATENT ABSTRACTS OF JAPAN vol. 10, no. 158
(E-409) (2214) 6 Juin 1986 & JP,A,61 013 634**
• **ABSTRACTS OF 1989 IEEE INT. CONF. ON
PLASMA SCIENCE - BUFFALO, USA - 22/24 MAY
1989 pages 145 - 146 JIANG ET AL. 'Real plasma
effects of microwave radiation propagating
perpendicularly to a magnetized plasma'**

## Description

Domaine technique

La présente invention a pour objet une source micro-onde linéaire pour le traitement de surfaces par plasma.

Etat de la technique antérieure

Dans les sources à résonance cyclotronique électronique, les ions sont obtenus en ionisant, dans une enceinte fermée du genre cavité hyperfréquence présentant un axe de symétrie, un milieu gazeux, constitué d'un ou plusieurs gaz ou de vapeurs métalliques. Cette ionisation résulte d'une interaction entre le milieu gazeux et un plasma d'électrons fortement accélérés par résonance cyclotronique électronique. Cette résonance est obtenue grâce à l'action conjuguée d'un champ électromagnétique de haute fréquence, injecté à une première extrémité de l'enceinte, et d'un champ magnétique à symétrie axiale régnant dans cette même enceinte.

Une demande de brevet EP-A-0 252 845 décrit une telle source d'ions à résonance cyclotronique qui comprend :

- une enceinte fermée ayant un axe de symétrie longitudinal, une première et une seconde extrémités orientées selon cet axe, cette enceinte contenant un gaz destiné à former par résonance cyclotronique un plasma confiné dans ladite enceinte ;
- un dispositif pour injecter à la première extrémité de l'enceinte un champ électromagnétique de haute fréquence ;
- une structure magnétique, disposée autour de l'enceinte et présentant un axe de symétrie confondu avec celui de l'enceinte, engendrant des champs magnétiques locaux, axiaux et radiaux, définissant au moins une nappe équimagnétique sur laquelle la condition de résonance cyclotronique électronique est satisfaite, cette structure magnétique comprenant:

  • une première et une seconde bobines disposées de part et d'autre et à égale distance d'un plan médian, perpendiculaire à l'axe longitudinal de l'enceinte et passant par le centre de la cavité, ces deux bobines étant parcourues par des courants de sens de circulation opposé, et
  • des moyens de concentration des lignes de forces magnétiques, entourant l'enceinte dans le plan médian et renforçant localement les champs magnétiques radiaux dans ce plan ;

- un système pour extraire de l'enceinte les ions formés, situé à la seconde extrémité de l'enceinte.

Plusieurs autres documents de l'art antérieur sont relatifs aux sources à plasma.

La demande de brevet WO-A-92/21136 (Material Research Co.) décrit un appareil de traitement de "wafers" électronique qui présente les caractéristiques suivantes :

- le dispositif est de révolution autour d'un axe ;
- la puissance micro-onde est appliquée par une cavité cylindrique excitée par un ensemble de boucles réparties ;
- le champ magnétique est créé par des aimants distribués. Ce champ a une symétrie de révolution et il est fortement inhomogène ;
- pour compenser cette inhomogénéité du champ et du plasma les aimants tournent.

Une telle source à géométrie de révolution n'est pas transposable à une géométrie linéaire.

L'abrégé japonais (volume 10, numéro 158, 6 juin 1986 ; JP-A-61 013 634) décrit un dispositif dont la configuration magnétique est de révolution. La configuration du type "CUSP" est celle utilisée dans les machines de fusion.

La configuration "CUSP" est utilisée pour éliminer dans la direction radiale les particules énergétiques, qui peuvent entraîner des défauts dans le dépôt.

Dans cette configuration le "CUSP" n'est pas un élément actif.

La demande de brevet EP-A-0 252 845 (CEA) décrit une source d'ions à résonance cyclotronique électronique. Cette source comprend une enceinte contenant un gaz destiné à former un plasma confiné, un dispositif pour injecter à une extrémité de l'enceinte un champ électromagnétique HF, deux bobines disposées autour de l'enceinte, alimentées en opposition, disposées de part et d'autre d'un plan médian perpendiculaire à l'axe longitudinal de l'enceinte, un blindage en fer doux ayant la forme d'un anneau entourant l'enceinte, situé dans le plan médian, les bobines et le blindage définissant au moins une nappe équimagnétique sur laquelle la condition de résonance cyclotronique électronique est satisfaite, et un système pour extraire des ions formés, situé à la seconde extrémité de l'enceinte.

Plusieurs documents de l'art antérieur concernent des coupleurs :

- l'article intitulé "Lower-hybrid plasma heating via a new launchers - The multijunction grill" de Gormezano et al (Nuclear Fusion, vol. 25, no. 4, 1985, Vienna AT, pages 419-423) ;
- l'article intitulé "Coupling of slow waves near the lower hybrid frequency in JET" de Litaudon et al (Nuclear Fusion, vol. 30, no. 3, 1990, Vienna AT, pages 471-484) ;
- l'article intitulé "A 4 waveguide multijunction antenna for L.H.H. in PETULA" de N'Guyen et al. (Proceedings of the 13th symposium on fusion technology, vol. 1, 24-28 septembre 1984, Varese IT, pages 663-668) ;

- l'article intitulé "The 15 Mw microwave generator and launcher of the lower hybrid current drive experiment on JET" de Pain et al (Proceedings of the IEEE 13th symposium on fusion engineering, 2-6 octobre 1989, vol. 2, Knoxville, US, pages 1083-1088) ;

- l'article intitulé "First operation of multijunction launcher on JT-60" de Ikeda et al (Proceedings of the 8th topical conference on radiofrequency power in plasmas, 1-3 mai 1989, no. 190, Irvin, CA, pages 138-141);

- l'article intitulé "Technological developments in lower hybrid coupling structures in FT and FTU" de Ferro et al (Proceedings of the 11th symposium on fusion engineering, 18-22 novembre 1985, vol. 2, Austin, Texas, pages 1210-1213) ;

- le brevet US-A-4 110 595 (Brambilla et al.).

Dans tous ces documents l'objectif est de ralentir une onde. Ceci est fait en associant des guides par le grand côté et en imposant un déphasage régulier $\Delta\varphi$ entre chaque guide. Le couplage de l'onde est obtenu en plaçant cet ensemble de guides perpendiculairement au champ magnétique.

Dans tous ces documents il y a superposition de modules UHF indépendants pour mettre le maximum de puissance dans la surface disponible d'une machine de fusion (JET, JT 60, TORE SUPRA), ces guides étant associés dans chaque module par le grand côté et étant perpendiculaires au champ magnétique.

Le domaine de l'invention est, par contre, celui de la production de nappes de plasma de très grande longueur (par exemple supérieure à un mètre) et du couplage d'une puissance micro-onde à cette nappe de plasma dans le but de réaliser le traitement de surfaces de grandes dimensions.

Pour ce faire, l'invention a pour objet de résoudre un certain nombre de problèmes existant dans les dispositifs de l'art connu, pour réduire le coût, faciliter l'utilisation, obtenir de meilleurs résultats, notamment :

- réalisation d'une configuration magnétique plane dont le plan de symétrie est identique à celui de la nappe de plasma ;

- production sur toute la largeur de la nappe de plasma d'un champ magnétique constant permettant d'obtenir la condition de résonance entre la fréquence de l'onde et la fréquence cyclotronique électronique sur toute la largeur de cette nappe ;

- possibilité de faire varier la configuration magnétique pour adapter les caractéristiques du plasma au type de traitement des surfaces choisi ;

- utilisation du coupleur assurant une répartition uniforme de la puissance micro-onde sur la nappe de plasma et un plan d'onde perpendiculaire au champ magnétique ;

- modularité désirée de la source ;

- obtention d'une usure homogène de la cible ;

- obtention d'une bonne adaptation des différents éléments utilisés : coupleur, plasma, cible au dépôt désiré ;

- obtention d'un bon fonctionnement malgré les grandes dimensions de l'installation ;

- obtention d'un dépôt contrôlé de façon indépendante de la création de la nappe de plasma.

Exposé de l'invention

L'invention propose une source micro-onde linéaire qui fonctionne sans électrode, dans une large gamme de pressions et génère une nappe de plasma dont les dimensions sont adaptées au traitement de grandes surfaces.

Cette source micro-onde linéaire pour le traitement de surfaces par plasma est caractérisée par la mise en oeuvre :

- d'une enceinte étanche ;

- d'un ensemble de bobines et/ou d'aimants permettant de générer des configurations magnétiques planes dont le plan de symétrie correspond à celui de la nappe de plasma ;

- des moyens de couplage entre les sources de puissance micro-onde et la nappe de plasma dans l'enceinte ;

- au moins une cible, constituée d'au moins un élément à déposer, isolée électriquement de l'enceinte et portée à une tension de polarisation par rapport à la nappe de plasma ;

- des moyens de pompage pour faire le vide dans l'enceinte ;

- des moyens d'injection de gaz pour le contrôle des espèces ioniques de la nappe de plasma ;

- d'un champ magnétique qui possède un plan de symétrie confondu avec celui de la nappe de plasma et celui de l'enceinte ;

- d'un champ magnétique constant dans la direction de la largeur de la nappe de plasma, ce qui permet d'obtenir la condition de résonance $2\pi f_0 = e\, B_{RES}\,/\,m$ sur toute la largeur de la nappe de plasma.

En plus de l'avantage de fonctionner sans électrode dans une large gamme de pression et de générer une nappe de plasma dont les dimensions sont adaptables à l'application retenue, la source micro-onde de l'invention peut, selon la disposition des bobines et des aimants permanents, fonctionner avec plusieurs types de configurations magnétiques :

- une configuration plane de type "MIROIR MAGNETIQUE" permettant de créer une nappe de plasma très dense et un flux ionique dont les caractéristiques sont particulièrement bien adaptées au procédé de revêtement de pièces de grandes dimensions par pulvérisation de cible ;

- une configuration plane de type "CUSP MAGNETIQUE" adaptée à la production d'une nappe de plasma métallique pour le dépôt de couches minces métalliques ou d'alliage sur des substrats ;
- une configuration plane de type "HYBRIDE" favorisant la production d'ions multichargés pour les besoins de l'implantation ionique sur de grandes surfaces.

Le couplage de la puissance micro-onde à la nappe de plasma est réalisé par des guides d'ondes associés selon leurs grands ou leurs petits côtés, permettant une répartition uniforme de cette puissance sur toute la nappe de plasma et l'excitation d'un plan d'onde perpendiculaire au champ magnétique.

Dans une réalisation préférentielle le coupleur est constitué de modules UHF identiques, chaque module regroupant plusieurs guides associés selon le grand côté et alimenté à partir d'un guide principal par l'intermédiaire d'une multijonction plan E ou plusieurs guides secondaires associés selon le petit côté et alimenté à partir d'un guide principal par l'intermédiaire d'un "taper" E et H et d'un convertisseur de mode. A la fréquence de 2,45 GHz, cette solution est particulièrement simple et économique car chaque module UHF peut être alimenté par un émetteur micro-onde de moyenne puissance de type magnétron.

Cette méthode d'association de guides permet d'adapter la surface de la nappe de plasma, générée dans la source, aux dimensions des pièces à traiter et en particulier au cas des pièces de grandes dimensions.

Avantageusement les moyens de couplage sont réalisés, au moins partiellement, en un matériau qui est celui de la cible, ce qui permet l'obtention de dépôts métalliques de haute qualité, la contamination par les impuretés étant alors réduite. L'ensemble de la source est à la masse. L'enceinte a une forme parallélépipédique. La fréquence du champ électromagnétique produit à l'intérieur de l'enceinte est située dans la plage 1 GHz - 10 GHz.

Dans une première variante de réalisation, les moyens pour créer un champ magnétique comprennent des bobinages, la longueur des bobinages étant supérieure à la longueur de l'enceinte à vide de manière à éliminer les effets de bord liés au retour du courant.

Dans une seconde variante de réalisation, les moyens pour créer un champ magnétique comprennent des blocs aimants permanents disposés de part et d'autre de l'enceinte à vide, les blocs aimants permanents étant prolongés au-delà de l'enceinte à vide pour éviter les effets de bord.

Dans un premier mode de réalisation, la source selon l'invention présente une configuration magnétique de type miroir comprenant deux ensembles de bobinage identiques parcourus par des courants égaux et de même sens, ou deux blocs d'aimants identiques évidés dans leur partie centrale disposés de part et d'autre de l'enceinte à vide, le champ magnétique présentant deux maxima $B_{MAX}$ et un minimum $B_{MIN}$ entre ces maxima, la condition $B_{MAX} > B_{RES} > B_{MIN}$ étant satisfaite sur toute la largeur de la nappe de plasma, $B_{RES}$ étant la valeur du champ magnétique pour laquelle la pulsation gyromagnétique de l'électron est égale à la pulsation de l'onde électromagnétique utilisée pour créer le plasma.

Par rapport à la technique magnétron couramment utilisée pour ce procédé de revêtement, ce type de source offre de nombreux avantages :

- l'ionisation du gaz, la pulvérisation de la cible, la recombinaison des atomes de la cible sur la pièce à traiter sont très fortement découplées, ce qui donne une très grande souplesse dans la mise en oeuvre du procédé. La densité ionique $n_i$ dans la source est fixée par le débit de gaz $\Gamma o$ et la puissance micro-onde $P_{UHF}$ et la vitesse des ions $V_2$ qui bombardent la cible par la tension de la cible $V_c$. La vitesse de dépôt sur la pièce qui est proportionnelle au flux d'ions sur la cible peut donc être contrôlée de façon indépendante par les trois paramètres $\Gamma o$, $P_{UHF}$, $V_c$. Ceci permet par exemple d'optimiser le coefficient de "sputtering" des ions sur la cible par la tension cible $V_c$ et d'optimiser la densité dans la source $n_i$ avec les paramètres $\Gamma o$ et $P_{UHF}$. D'autre part, dans ces sources les atomes neutres émis par la cible se recombinent sur la pièce à traiter dans une région qui n'est pas en regard du plasma. De ce fait, à flux d'ions constant délivré par la source, la pression dans le bâti de travail peut être abaissée par l'utilisation d'un pompage différentiel ;
- le mécanisme d'ionisation par l'onde utilisé permet à flux d'ions donné sur la cible, de travailler avec des pressions plus faibles dans la source, ce qui limite la densité des gaz occlus dans le dépôt ;
- le bilan en matière est amélioré car toute la surface de la cible est bombardée par la nappe de plasma. D'autre part, la cible peut être chargée sans démontage de la source ou défiler devant le faisceau d'ions pour la mise en oeuvre d'un processus continu.

Dans ce mode de réalisation la source peut être utilisée pour délivrer un faisceau d'ions ou d'électrons.

Pour ce mode de fonctionnement la cible est remplacée par des électrodes d'extraction. La première électrode en regard de la nappe de plasma est placée au potentiel de l'enceinte à vide, la seconde électrode polarisée positivement pour extraire les électrons ou négativement pour extraire les ions.

Dans un second mode de réalisation, la source selon l'invention présente une configuration magnétique à "CUSP" dans laquelle les courants qui parcourent les bobinages ou le vecteur aimantation dans les blocs d'aimants sont de signes opposés, les bobinages et les aimants étant dimensionnés pour satisfaire la condition $B_{xMAX}$, $B_{ymAX} > B_{RES}$ sur toute la largeur de la nappe de plasma.

En plus de la possibilité de réaliser des dépôts sur des substrats de grandes dimensions, ce type de source, de par son principe de fonctionnement, présente par rapport aux autres sources généralement utilisées plusieurs avantages importants :

- le mécanisme d'ionisation par l'onde élimine la pollution du dépôt liée à l'utilisation de cathode émissive et permet un fonctionnement de la source à basse pression, ce qui limite a densité des gaz occlus ;
- la configuration magnétique à "CUSP" ajoute une nouvelle possibilité de contrôle de la nature et de la qualité du dépôt.

Ce dernier point est un élément important de la souplesse d'utilisation de ces sources.

Dans un troisième mode de réalisation, la source selon l'invention présente une configuration magnétique hybride générée par la superposition :

- d'un champ magnétique à miroir créé par deux bobinages qui entourent l'enceinte à vide ;
- d'un champ magnétique transversal produit par deux blocs d'aimants permanents disposés de part et d'autre de l'enceinte à vide.

L'avantage de cette configuration est de générer une surface plane dans le plasma où la condition de résonance $|B| = B_{RES}$ est satisfaite en tous points de cette surface. Cette propriété est essentielle pour la formation d'ions multichargés dans le plasma.

Le domaine d'application de ce type de source recouvre tous les domaines d'application des sources d'ions classiques: implantation ionique, dépôt sous assistance ionique... L'avantage unique de ce type de source est de permettre la mise en oeuvre de ces procédés au niveau industriel grâce aux dimensions et aux performances du faisceau d'ions généré.

Dans chacun de ces modes de réalisation, l'absence de cathode émissive permet de faire fonctionner ces sources avec des gaz réactifs en régime permanent avec une fiabilité et une durée de vie remarquables.

Brève description des dessins

- Les figures 1a à 1c illustrent une source à miroirs magnétiques selon l'invention dans une configuration utilisant des bobines ;
- les figures 2a à 2c illustrent une source à miroirs magnétiques selon l'invention dans une configuration utilisant des aimants permanents ;
- la figure 2d illustre une variante de la source illustrée aux figures 2a à 2c ;
- les figures 3a et 3b illustrent une variante de la source illustrée aux figures 1a et 1c ;
- les figures 4 à 6 illustrent différentes caractéristiques de la source selon l'invention ;

- les figures 7 à 7c illustrent une source à "CUSP" selon l'invention dans une configuration utilisant des bobines ;
- les figures 8 à 8c illustrent une source à "CUSP" selon l'invention dans une configuration utilisant des aimants permanents ;
- la figure 9 illustre une source micro-onde à configuration hybride.

Exposé détaillé de modes de réalisation

Selon l'invention des propriétés spécifiques d'une nappe de plasma créée dans une source d'ions à résonance cyclotronique et génération de plasma, telles que densité, taux d'ionisation, dimensions, reposent sur la mise en oeuvre simultanée :

- d'une configuration magnétique linéaire ;
- de l'ionisation du gaz par une onde de fréquence $f_o$ ;
- de l'utilisation des propriétés résonnantes de cette onde à la résonance cyclotronique électronique $f_o = f_{ce} = eB/m$ (e: charge de l'électron; B : module de champ magnétique ; m : masse de l'électron) et de ses possibilités de se propager à forte densité sous la forme du mode hybride inférieur ;
- de l'excitation uniforme de cette onde dans toute la nappe de plasma au moyen d'un coupleur constitué de guides d'ondes, identiques et associés côte à côte.

La configuration magnétique d'une telle source est produite par des bobinages ou des aimants permanents. Selon le sens et l'intensité du courant dans les bobinages ou de l'aimantation dans les aimants permanents, il est possible d'obtenir trois classes de configuration magnétique :

- une configuration magnétique de type miroir;
- une configuration magnétique de type "CUSP" ;
- une configuration magnétique hybride.

Ces sources, selon la configuration magnétique utilisée, génèrent un plasma dont les caractéristiques sont spécialement adaptées aux besoins :

- du revêtement par pulvérisation (première configuration) ;
- du dépôt de couches minces métalliques (seconde configuration) ;
- de l'implantation et de l'assistance ionique (troisième configuration).

Dans la description qui suit, la fréquence $f_o$ de l'onde n'est pas précisée car la source de l'invention fonctionne dans une large gamme de fréquences, de quelques centaines de mégahertz (MHz) à plusieurs dizaines de gigahertz (GHz). A l'intérieur de cette gamme, la plage 1-10 GHz présente plusieurs avantages : il existe des émetteurs de puissance, les performances des aimants permanents sont compatibles avec la condition de résonance de l'onde $f_o = eB / 2\pi m$, les caractéristiques du plasma étant adaptées aux applications visées. En particulier a fréquence industrielle de 2,45 GHz, pour laquelle il existe des émetteurs de petite et moyenne puissances de type magnétron et des émetteurs de forte puissance de type klystron, offre une grande souplesse dans la répartition de cette puissance sur les guides du coupleur et un bon compromis entre le prix de ces sources et les performances du plasma.

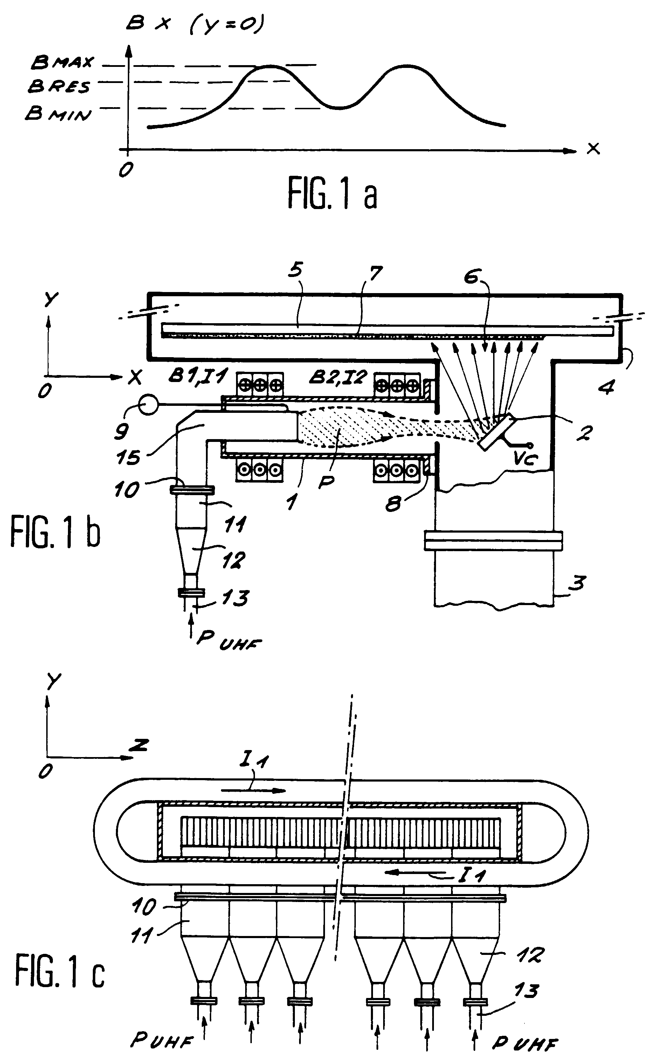

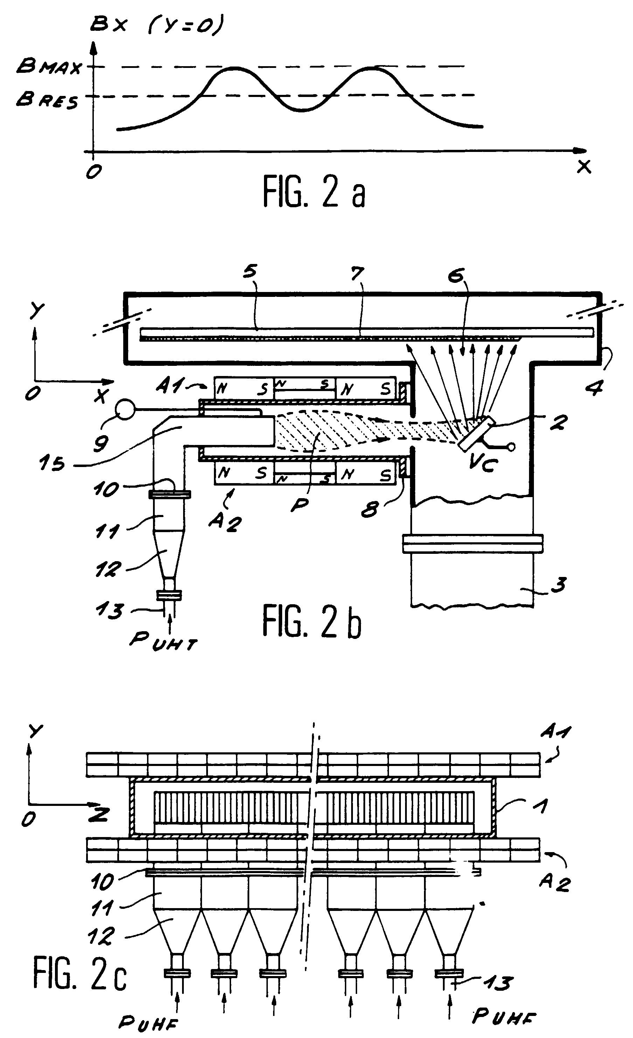

le schéma de principe d'une source de type à miroir magnétique utilisée pour le revêtement d'une pièce par pulvérisation d'une cible 2 par bombardement ionique est schématisé sur les figures 1a à 1c et 2a à 2c. Sur les figures 1b et 1c le miroir magnétique est produit par des bobinages $B_1$ et $B_2$, sur les figures 2b et 2c par des aimants permanents $A_1$ et $A_2$. Les figures 1a et 2a montrent la variation du champ magnétique Bx dans le plan de symétrie de la source (Y = 0). Les figures 1b et 2b correspondent à une coupe de la source selon une section droite (plan xOy) et les figures 1c et 2c à une coupe selon une section longitudinale (plan yOz). Cette source est constituée d'une enceinte à vide 1, d'un ensemble de bobinage $B_1$, $B_2$ ou d'aimants permanents $A_1$, $A_2$ créant la configuration magnétique et d'un coupleur répartissant dans l'enceinte la puissance UHF générée par le (ou les) émetteur(s) micro-onde.

L'enceinte à vide 1 a une forme parallélépipédique. La hauteur de sa section droite (plan xOy ; les figures 1b et 2b) est choisie pour permettre le passage des guides d'ondes du coupleur. La largeur est déterminée par les dimensions des bobinages et des aimants. La longueur de sa section longitudinale (plan yOz) n'est fixée que par la dimension des pièces à traiter. L'enceinte 1 se raccorde au bâti de travail 4 par l'intermédiaire d'une bride de raccordement 8. Selon le type d'utilisation, le vide dans l'enceinte est assuré par un groupe de pompage autonome ou par le groupe de pompage 3 du bâti de travail.

Sur les figures 1b et 1c, et 2b et 2c, le coupleur qui permet le transfert de la puissance micro-onde $P_{UHF}$ vers la nappe de plasma est constitué de guides associés selon le grand côté. Dans cet exemple les guides sont regroupés par modules identiques. Chaque module UHF est alimenté par un guide principal 13 via un adaptateur, une transition 12 guide principal/guide surdimensionné, une division plan E 11, une fenêtre étanche 10 et plusieurs guides secondaires 15. L'association de ces modules UHF permet d'adapter la dimension de la nappe de plasma générée à la dimension des pièces à traiter.

Le coupleur émet une nappe de plasma P en direction de la cible 2 polarisée à la tension $V_c$. Un flux 6 de neutres issus de la cible est alors émis en direction de la pièce à traiter 5, sur laquelle a lieu un dépôt 7.

L'enceinte 1 est équipée d'au moins un système d'injection de gaz 9 pour le contrôle des espèces ioniques du plasma.

Dans la configuration représentée aux figures 1b et 1c, le champ magnétique est produit par deux ensembles de bobinages $B_1$ et $B_2$ parcourus par des courants $I_1$ et $I_2$ de même sens. Ces bobinages entourent l'enceinte à vide 1. Leur longueur est supérieure à celle de l'enceinte pour éliminer les effets de bord liés au retour du courant. Dans ces conditions le potentiel vecteur $\vec{A}$ généré par ces bobinages a une seule composante dans le volume de l'enceinte $A_z(x, y)$ et les deux composants du champ magnétique Bx et By sont fixées par les relations

$$B_x = \frac{\partial A_z}{\partial y}$$

et

$$B_y = \frac{\partial A_z}{\partial x}.$$

Pour deux ensembles de bobinages $B_1$ et $B_2$ identiques parcourus par des courants $I_1$ et $I_2$ égaux et de même sens, le champ magnétique B dans le plan de symétrie (y = 0) a la forme classique des champs dits à miroirs magnétiques utilisés dans les machines de fusion à géométrie de révolution. Ce champ présente deux maxima $B_{MAX}$ au centre des bobinages et un minimum $B_{MIN}$ entre les bobinages. La forme des bobinages, la distance qui les sépare et les courants qui les parcourent sont choisis de façon à satisfaire la condition $B_{MAX} > B_{RES} > B_{MIN}$ sur toute la largeur de la nappe de plasma. $B_{RES}$ est la valeur du champ magnétique pour laquelle la pulsation gyromagnétique de l'électron ce = e $B_{RES}$ / m est égale à la pulsation de l'onde électromagnétique utilisée pour créer le plasma $\omega_o = 2\pi f_o$ = e $B_{RES}$ /m.

L'utilisation de bobinages pour générer la configuration magnétique a l'avantage d'une grande souplesse de fonctionnement de la source. A l'intérieur de la condition $B_{MAX} > B_{RES} > B_{MIN}$ les caractéristiques du miroir magnétique peuvent facilement être modifiées en jouant sur les courants $I_1$ et $I_2$, la distance entre les bobinages, le nombre d'enroulements alimentés dans chaque bobinage....

Ceci permet en particulier :

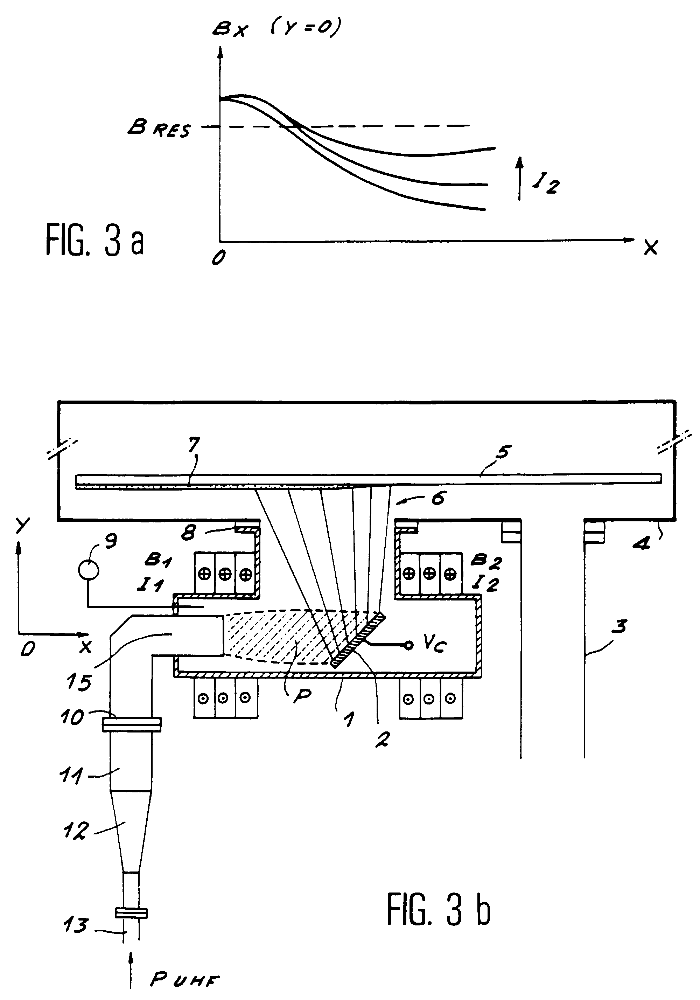

- d'ajuster la position de la résonance cyclotronique ($B_{RES}$) dans le miroir et par rapport au coupleur pour optimiser les caractéristique du plasma (densité, température électronique, pression de travail) ;
- de modifier le rapport miroir pour agir sur le flux de fuite du plasma côté extraction, ou contrôler la surface d'impact du plasma sur la cible. Les figures 3a et 3b illustrent une variante de la source illustrée aux figures 1a à 1c avec un miroir magnétique asymétrique. Dans ce cas la cible est rapprochée du coupleur et placée entre les bobines $B_1$ et $B_2$. Selon le processus de dépôt par pulvérisation retenu, cette variante de fonctionnement de la source est intéressante car elle permet de faire varier très facilement, en jouant sur le courant $I_2$, la densité du flux d'ions qui bombarde la cible ;

- d'ajuster le gradient de champ magnétique $\partial B/\partial_x$ à la fréquence de l'onde utilisée.

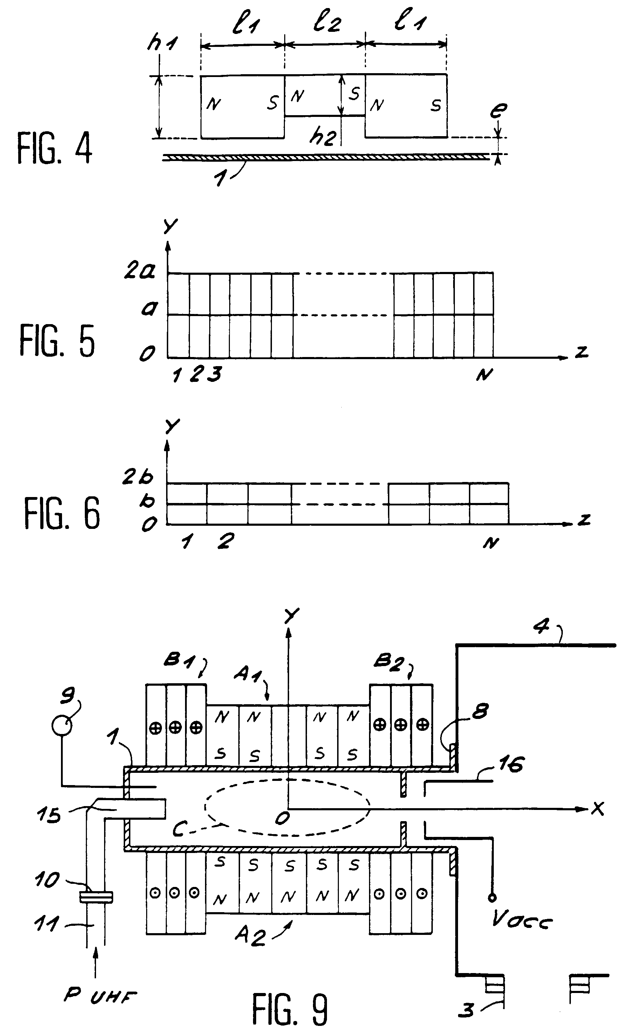

Une configuration linéaire à miroir magnétique analogue à la configuration représentée sur les figures 1b et 1c peut être obtenue à partir d'aimants permanents parallélépipédiques en samarium-cobalt ou fer-néodyme-bore. Ces aimants sont assemblés pour former deux blocs identiques $A_1$ et $A_2$ disposés de part et d'autre de l'enceinte à vide, comme représenté à la figure 2b. Dans la direction longitudinale (Oz) ces blocs sont prolongés au-delà de l'enceinte à vide pour éviter les effets de bord, comme représenté sur la figure 2c. Ces deux blocs d'aimants $A_1$ et $A_2$ sont évidés dans la partie centrale. Les caractéristiques du miroir magnétique ($B_{MAX}$, $B_{MIN}$, rapport et longueur miroir) sont fixés par les largeurs et hauteurs des deux blocs externes du miroir $l_1$ et $h_1$ et du bloc central $l_2$ et $h_2$, tel quel représenté sur la figure 4.

A l'intérieur de la condition $B_{MAX} > B_{RES} > B_{MIN}$, les caractéristiques du miroir peuvent être ajustées en jouant sur la distance aimant-enceinte, e, sur les entrefers entre les blocs d'aimants, ou par l'apport de pièces métalliques, ces pièces étant disposées, de manière connue de l'homme de l'art, pour modifier les lignes de champ magnétique.

Le grand avantage de l'utilisation des aimants est de créer une configuration magnétique sans source de puissance électrique. Comme par ailleurs la puissance micro-onde est transmise au plasma par des guides d'ondes, l'ensemble de la source est à la masse, ce qui facilite l'intégration de ce type de source dans un processus industriel.

La puissance ainsi délivrée par le (ou les) émetteur(s) micro-onde $P_{UHF}$ est introduite dans l'enceinte 1 au moyen de guides d'ondes situés à l'extrémité du miroir magnétique.

A faible puissance, les champs électriques $\tilde{E}(\omega_o)$ et magnétique $\tilde{H}(\omega_o)$ excités dans les guides sont essentiellement perpendiculaires à la direction du champ magnétique, ce qui permet la propagation de l'onde sous la forme du mode Whistler. Dans le miroir l'onde rencontre la condition de résonance $\omega_o = 2\pi f_o = e\,B_{RES}/m$. Au voisinage de cette zone l'interaction onde-électrons devient résonnante et une partie importante de l'énergie de l'onde est transférée aux électrons sous la forme d'énergie cinétique perpendiculaire aux lignes de force du champ magnétique. Du fait de ce gain en énergie, les électrons accélérés se trouvent piégés dans la configuration magnétique, ce qui augmente leur libre parcours moyen et assure une ionisation efficace du gaz dans un domaine de pression qui n'est pas accessible aux décharges classiques, où l'ionisation du gaz se fait par l'application d'un champ électrique statique.

Un autre avantage de l'utilisation du mode Whistler est d'éviter la limitation de la densité électronique du plasma ne, due à la charge d'espace par la condition :

$$\omega_o = 2\pi f_o < \omega pe = |e^2 ne/ \varepsilon_o\, m|^{1/2}$$

Par exemple à la fréquence de 2,45 GHz, une densité de puissance de 10 à 20 $W/cm^2$ ($w/cm^2$) permet d'obtenir avec un gaz d'argon à la pression de 2 à $5.10^{-4}$ mbar une densité voisine de $10^{12}$ particules/$cm^3$ (p/$cm^3$), soit environ 10 fois la densité fixée par la condition de coupure $\omega_o = \omega_p$.

A plus forte puissance, l'augmentation de la densité entraîne une forte diminution de la vitesse de phase de l'onde dans la direction du champ magnétique et l'onde se propage perpendiculairement aux lignes magnétiques sous la forme du mode hybride inférieur. Pour ce régime de fonctionnement la densité du plasma est fixée par la relation de dispersion du mode hybride inférieur défini comme suit :

$$\omega_o^2 = \frac{\omega_{pi}2}{1+\omega_{pe}^2 / \omega_{ce}^2}\left[1+\frac{K_{//}}{K}\frac{m_i}{m}\right]$$

où $\omega_{pe}$, i sont les pulsations plasma électronique et ionique, $\omega_{ce}$ la pulsation cyclotronique électronique, m la masse de l'électron et de l'ion, k le nombre d'onde et $_{//}$ sa composante le long du champ magnétique. Pour l'exemple considéré précédemment à la fréquence de 2,45 GHz, une densité de puissance de 100 à 200 $W/cm^2$ permet d'obtenir des densités de l'ordre de $10^{13}$ particules/$cm^3$ (p/$cm^3$), qui ne sont pas accessibles dans les décharges pour les mêmes pressions de travail.

L'énergie électromagnétique étant localisée à l'intérieur des guides d'ondes et, aux pressions de travail de la source, le mouvement des particules étant lié aux lignes magnétiques, les dimensions du plasma généré par chaque guide sont essentiellement déterminées par les dimensions de ce guide. L'association jointive de guides permet de générer un plan d'onde perpendiculaire au champ magnétique sur toute la surface des guides, d'obtenir la condition de résonance $2\pi f_o = e B_{RES}/m$ sur la largeur de cette surface et de créer une nappe de plasma dont les dimensions sont fixées par le nombre de guides associés ou le nombre de guides alimentés, comme expliqué ci-dessous :

■ Ces guides peuvent être associés par leur grand côté a sous forme de rangées et colonnes, comme représenté sur al figure 5. C'est ce principe qui est utilisé pour le couplage de la puissance dans les sources schématisées sur les figures 1b et 1c, et 2b et 2c.

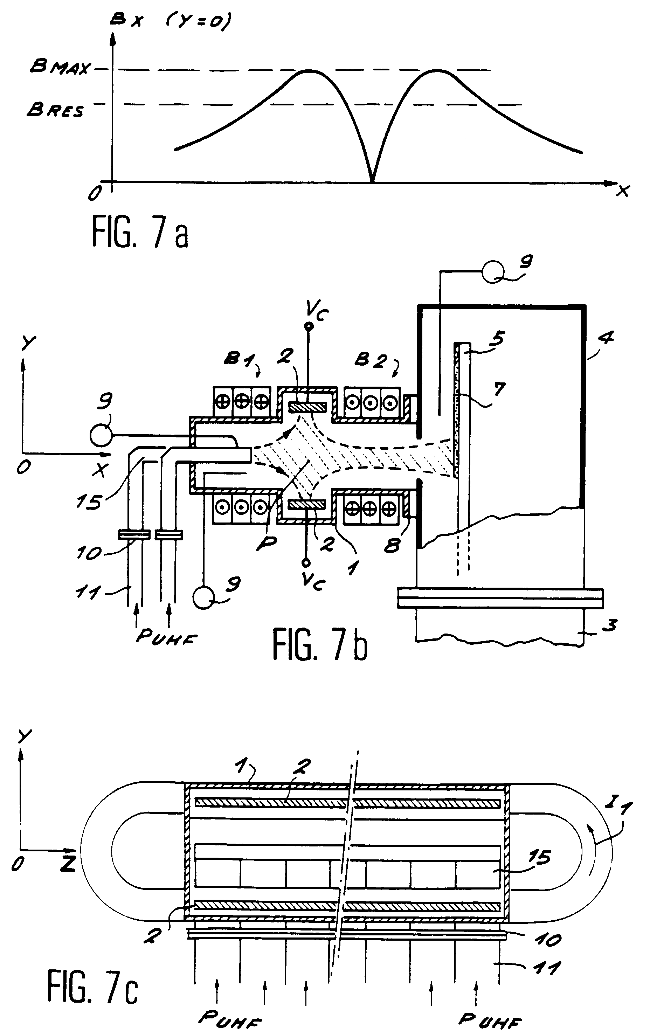

■ Ces guides peuvent être associés par leur petit côté b, comme représenté sur la figure 6. Les coupleurs des sources schématisées sur les figures 7a à 7c et 8a à 8c et 9 utilisent ce principe.

Cette méthode d'association de guides permet d'adapter la surface de la nappe de plasma générée dans la source aux dimensions des pièces à traiter et en particulier au cas des pièces de grandes dimensions. Par exemple à la fréquence de 2,45 GHz, une association par le grand côté de N = 24 guides standards (a = 8,6 cm, b = 4,3 cm) génère une nappe de plasma de 8,6 cm de hauteur et 100 cm de longueur et l'association de N = 12 de ces mêmes guides selon le petit côté génère une nappe de même longueur et de hauteur 4,3 cm.

La technique mise en oeuvre pour distribuer de façon uniforme la puissance micro-onde entre les guides du coupleur dépend de l'application retenue. Cette puissance est proportionnelle à la largeur de la nappe et donc aux dimensions des pièces à traiter. Cette puissance peut être fournie par exemple :

-   par un ensemble d'émetteurs identiques de faible puissance $P_{UHF} \cong 1$ kW (KW) de type magnétron, chaque magnétron alimentant via un adaptateur et une fenêtre étanche un guide du coupleur;
-   par un ensemble d'émetteurs identiques de moyenne puissance $P_{UHF} \cong 5$ kW (KW) de type magnétron, chaque magnétron alimentant plusieurs guides du coupleur regroupés en modules UHF identiques, via un adaptateur, une division plan E et une fenêtre étanche ;
-   par un émetteur de forte puissance $P_{UHF} \geq 50$ kW (Kw) de type klystron et une répartition égale de cette puissance entre les guides du coupleur par les techniques classiques de division par coupleur 3 db ou par coupleurs à branches ("Branch Guide Couplers" en anglais) et d'adaptation automatique.

Une réalisation préférentielle de la source consiste à utiliser un coupleur avec des guides associés selon leur petit côté figures 7a à 7c et 8a à 8c et 9. Cette solution permet:

-   de réduire le volume à magnétiser et de ce fait le volume des aimants permanents et des bobinages et le prix de la source ;
-   de réduire la puissance micro-onde à mettre en oeuvre ;
-   de faciliter la réalisation du coupleur en réduisant le nombre de guides à associer pour traiter une largeur de pièce donnée ;
-   de faciliter la répartition uniforme de la puissance micro-onde entre les guides du coupleur en alimentant chacun de ces guides par un émetteur de type magnétron via un adaptateur ou en alimentant plusieurs guides du coupleur regroupés en modules UHF identiques via un "taper" E et H suivi d'un convertisseur de mode adapté au nombre des guides du module.

Les figures 1a à 1c et 2a à 2c montrent un exemple classique d'utilisation de ce type de sources pour le revêtement de pièces par pulvérisation de cible. Le gaz neutre (Ag, Xe, ...) introduit dans l'enceinte à vide est ionisé par l'onde et forme une nappe de plasma dont les dimensions sont fixées par celles du coupleur. Dans ce plasma les particules ions et électrons suivent les lignes magnétiques et interceptent la cible sur une largeur fixée par l'épanouissement des lignes de force et sur toute la longueur de la nappe de plasma. La cible (Ti, Cr, ...) est isolée électriquement de l'enceinte. L'application d'une tension négative par rapport au plasma entraîne un bombardement de la cible par les ions du plasma et l'émission d'un flux d'atomes qui se déposent sur la pièce à traiter.

Par rapport à la technique magnétron couramment utilisée pour ce procédé de revêtement, ce type de source offre de nombreux avantages :

-   l'ionisation du gaz, la pulvérisation de la cible, la recombinaison des atomes de la cible sur la pièce à traiter sont très fortement découplées, ce qui donne une très grande souplesse dans la mise en oeuvre du procédé. La densité ionique $n_i$ dans la source est fixée par le débit de gaz $\Gamma_0$ et la puissance micro-onde $P_{UHF}$ et la vitesse des ions $V_i$ qui bombardent la cible par la tension de la cible $V_c$. La vitesse de dépôt sur la pièce qui est proportionnelle au flux d'ions sur la cible peut donc être contrôlée de façon indépendante par les trois paramètres $\Gamma_0$, $P_{UHF}$, $V_c$. Ceci permet par exemple d'optimiser le coefficient de "sputtering" des ions sur la cible par la tension cible $V_c$ et d'optimiser la densité dans la source $n_i$ avec les paramètres $\Gamma_0$, et $P_{UHF}$. D'autre part, dans ces sources les atomes neutres émis par la cible se recombinent sur la pièce à traiter dans une région qui n'est pas en regard du plasma. De ce fait, à flux d'ions constant délivré par la source, la pression dans le bâti de travail peut être abaissée par l'utilisation d'un pompage différentiel ;
-   le mécanisme d'ionisation par l'onde utilisée permet, à flux d'ions donné sur la cible, de travailler avec des pressions plus faibles dans la source, ce qui limite la densité des gaz occlus dans le dépôt ;
-   le bilan en matière est amélioré car toute la surface de la cible est bombardée par la nappe de plasma. D'autre part, la cible peut être changée sans démontage de la source ou défiler devant le faisceau d'ions pour la mise en oeuvre d'un processus continu.

Le transfert d'énergie onde/particules qui fixe les propriétés du plasma se fait à travers les électrons. Ces sources fonctionnent donc avec tous les gaz, mélanges de gaz et gaz réactifs.

Pour l'obtention de dépôts métalliques de haute qualité, la contamination par les impuretés peut être réduite par l'utilisation d'un coupleur réalisé, au moins en partie, avec le matériau de la cible utilisée.

D'autre part, dans ces sources, la densité de plasma varie linéairement avec la densité de puissance UHF et peut approcher $10^{14}$ particules/cm$^3$ (p/cm$^3$) pour une densité de puissance de l'ordre de 1 kW/cm$^2$ (KW/cm$^2$) à la fréquence de 2,45 GHz, ce qui correspond à un flux d'ions voisin de $10^{20}$/cm$^2$/s. Pour ces régimes de fort flux, la cible, l'enceinte et le coupleur doivent être refroidis. Dans la solution proposée chacun de ces éléments peut être refroidi par une technique simple, bien connue de l'homme de l'art, de double paroi avec circulation de fluide refroidisseur à l'intérieur, contrôlé de façon indépendante et les fenêtres UHF placées à l'abri du bombardement du plasma.

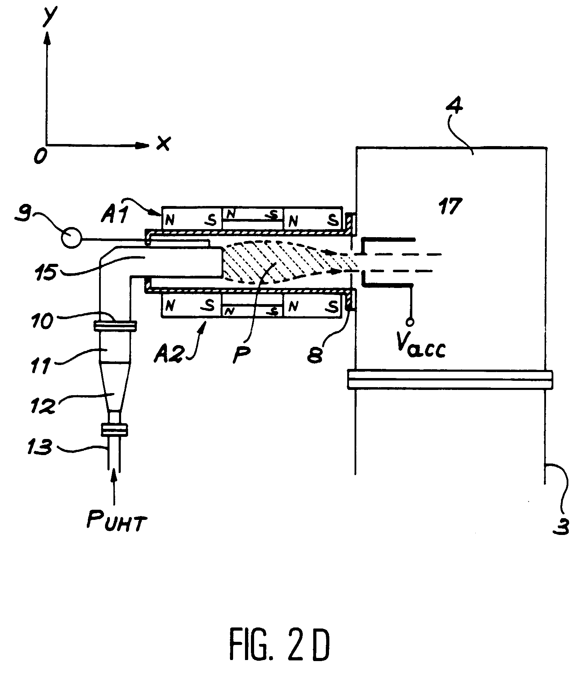

Dans ce mode de fonctionnement de la source, les performances en densité de la nappe de plasma peuvent être utilisées pour la génération de faisceaux d'ions ou d'électrons. La figure 2d illustre une utilisation de cette source pur la production de faisceaux d'ions ou d'électrons. Dans ce cas la cible est supprimée et remplacée par deux électrodes d'extraction qui permettent selon la polarisation d'extraire les ions ou les électrons sous la forme d'un faisceau linéaire 17 dont la longueur est fixée par celle du coupleur.

Un autre mode de réalisation est représenté par les sources micro-ondes linéaires à "CUSP" (ou à "point de rebroussement"). Le schéma de principe de ce type de source utilisée pour le dépôt de couches métalliques sur des substrats est schématisé sur les figures 13a à 13c et 14a à 14c. Les figures 13a à 13c correspondent au cas où la configuration magnétique est créée par des bobinages. Les figures 14a à 14c au cas où celle-ci est créée par des aimants permanents.

Sur ces figures, les éléments analogues à ceux des figures la à 1c et 2a à 2c sont représentés avec les mêmes références.

Une telle source utilise, comme la source à miroir magnétique décrite précédemment, le même mécanisme d'ionisation du gaz par l'onde, le même système de couplage par guides associés permettant d'obtenir un plan d'onde perpendiculaire au champ magnétique et la condition de résonance $2\,\pi f_o = B_{RES}\,/\,m$ sur toute la largeur de la nappe de plasma.

La particularité de ce type de source est que les courants qui parcourent les bobinages $B_1$ et $B_2$ (figure 13b) ou le vecteur aimantation dans les blocs d'aimants $A_1$ et $A_2$ (figure 14b) sont de signes opposés, ce qui permet de générer une configuration magnétique linéaire de type "CUSP". Cette configuration est caractérisée par une ligne de champ nul sur l'axe de symétrie de la configuration, un module du champ $B_x^2\,B_y^2 = B^2$ qui croît en tous points autour de cet axe, quatre maxima du champ au droit des bobinages ou des aimants, deux sur l'axe Ox, $B_{xMAX}$, deux dans le plan médian de la source $B_{yMAX}$. Les bobinages et les aimants sont dimensionnés pour satisfaire la condition

$$B_{xMAX},\ B_{yMAX} > B_{RES} = 2\,\pi\,f_o\,m\,/\,e$$

sur toute la largeur de la nappe de plasma.

A l'intérieur de cette condition les caractéristiques du "CUSP" peuvent varier en jouant sur les courants dans les bobinages, la distance entre les bobinages ou les aimants, par l'addition de pièces métalliques, disposées de manière connue de l'homme de l'art, pour modifier les lignes de champ magnétique.

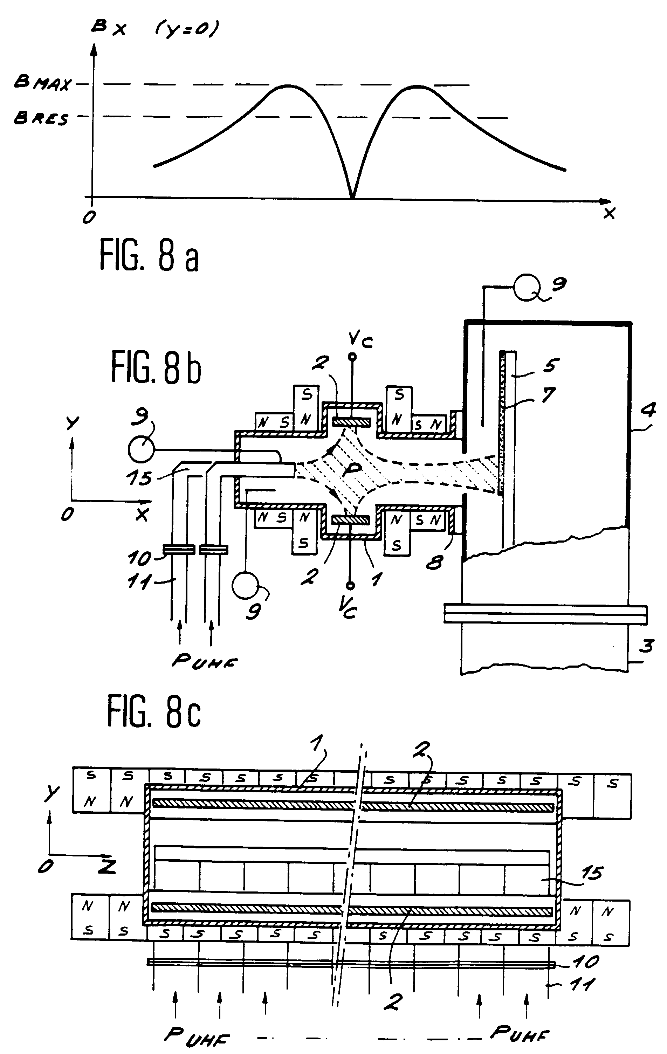

Dans cette configuration les lignes de champ magnétique issues des guides d'ondes du coupleur interceptent les deux cibles 2 placées dans l'enceinte et sont soumises au bombardement du plasma (figures 7b et 8b). Ces cibles sont isolées électriquement. L'application d'un potentiel positif entraîne un bombardement ionique de ces cibles et l'émission d'un flux de neutres. En pénétrant dans le plasma, ces neutres sont ionisés par les électrons énergétiques créés par l'onde et forment un plasma d'ions métalliques de la composition de la cible. Ces ions en suivant les lignes de champ viennent se recombiner sur le substrat placé à l'extrémité du "CUSP" pour former un dépôt métallique dont la largeur est fixée par l'épanouissement des lignes magnétiques et la longueur par celle du coupleur.

En plus de la possibilité de réaliser des dépôts sur des substrats de grandes dimensions, ce type de source, de par son principe de fonctionnement, présente par rapport aux autres sources généralement utilisées plusieurs avantages importants :

- le mécanisme d'ionisation par l'onde élimine la pollution du dépôt liée à l'utilisation de cathode émissive et permet un fonctionnement de la source à basse pression, ce qui limite la densité des gaz occlus ;
- la configuration magnétique à "CUSP" ajoute une nouvelle possibilité de contrôle de la nature et de la qualité du dépôt.

Ce dernier point est un élément important de la souplesse d'utilisation de ces sources. Le plasma qui assure le bombardement des cibles 2 et l'émission du flux d'atomes est généré par l'ionisation par l'onde d'un gaz porteur ou de vapeur métallique introduite dans l'enceinte. Les propriétés du dépôt sur le substrat sont fixées par les concentrations relatives des différentes espèces ioniques dans le plasma et les densités relatives des atomes neutres ou excités et des radicaux libres. Ces concentrations peuvent être contrôlées par des réglages indépendants :

- du flux ionique qui bombarde les cibles et qui dépend de la position, de la tension de polarisation et de la température de la cible, ou par la densité des lignes magnétiques interceptées par les cibles ;
-  de la composition, du débit du ou des gaz porteurs et de leur point d'injection dans la source.

Par exemple pour les dépôts carbones la concentration en carbone peut être contrôlée par le flux d'ions sur des cibles en graphite, par le choix du gaz porteur hydrocarbures (méthane, propane, ...) oxydes de carbone ($CO$, $CO^2$, ...) et l'injection indépendante localisée d'hydrogène, d'oxygène.

Ces sources fonctionnent également avec des cibles en matériaux réfractaires: oxydes d'uranium, oxydes d'aluminium, bore et ses composés, ... .Dans ce cas, le contrôle de la configuration magnétique permet de faire varier la densité des lignes magnétiques interceptées par les cibles et de ce fait la densité d'énergie déposée par le plasma et le flux de neutres réémis par la cible. Le contrôle de ce flux, du débit et de la nature du gaz porteur (azote, oxygène, ...) permet de modifier les propriétés du dépôt comme dans le cas des cibles métalliques.

L'absence de cathode émissive permet de faire fonctionner ces sources avec des gaz réactifs en régime permanent avec une fiabilité et une durée de vie remarquables.

Un autre mode de réalisation est représenté par les sources micro-ondes linéaires à configuration hybride. Une telle source, comme celles à miroir magnétique ou à "CUSP" décrites précédemment utilise le même mécanisme d'ionisation du gaz par l'onde et le même système de couplage de la puissance micro-onde au plasma.

La particularité de ce type de source réside dans la configuration magnétique. Cette configuration dite "HYBRIDE", schématisée sur la figure 15, est générée par la superposition :

-  d'un champ magnétique à miroir $B_y(x)$ créé par les deux bobinages $B_1$ et $B_2$ qui entourent l'enceinte à vide ;
-  d'un champ magnétique transversal $B_x(y)$ produit par les deux blocs d'aimants permanents $A_1$ et $A_2$ disposés de part et d'autre de l'enceinte à vide.

La propriété de cette configuration est que le lieu des points dans le plan xOy, où le module du champ magnétique $|B|^2 = [B_x^2 + B_y^2]^{1/2}$ est égal au champ magnétique résonnant $|B|=B_{RES}=2\pi f_o m/e$, est une courbe fermée C contenue à l'intérieur de l'enceinte à vide. Comme les champs $B_x$ et $B_y$ dans le volume de l'enceinte sont indépendants de la direction longitudinale Oz, la condition de résonance $|B| = B_{RES}$ est satisfaite sur la même courbe fermée C dans tous les plans xOy de l'enceinte à vide et donc sur toute la surface obtenue par translation de cette courbe dans la direction Oz.

L'existence de cette surface de résonance fermée permet d'obtenir dans une telle source un plasma avec une population électronique très énergétique qui, par ionisations successives, épluche les atomes neutres du gaz ou de la vapeur métallique introduits dans l'enceinte. Les ions, une ou plusieurs fois chargés selon la valeur de la pression du gaz dans la source, qui sont générés dans cette configuration magnétique, sont extraits de l'enceinte à vide par les électrodes d'extraction situées à l'extrémité du miroir sous la forme d'un faisceau linéaire dont la longueur est fixée par celle du coupleur.

Les propriétés des surfaces de résonance fermées ont été utilisées avec succès pour la production de faisceaux d'ions multichargés circulaires dans les configurations magnétiques à symétrie de révolution.

La présente invention, grâce à l'utilisation d'une configuration magnétique linéaire et à la génération d'un plasma en forme de nappe par l'association de guides selon leur petit ou grand côté, généralise le concept des surfaces de résonance fermées à symétrie de révolution à des surfaces linéaires et permet d'obtenir des faisceaux d'ions linéaires de très grandes dimensions avec de fortes densités de courant.

Le domaine d'application de ces sources recouvre tous les domaines d'application des sources d'ions classiques: implantation ionique, dépôt sous assistance ionique..... .

L'avantage de ce type de source est de permettre la mise en oeuvre de ces procédés au niveau industriel grâce aux dimensions et aux performances du faisceau d'ions générés.

## Revendications

1.  Appareil pour le traitement d'une surface à l'aide d'un flux de particules, obtenu à partir du bombardement d'une cible par un jet de plasma, comportant une source micro-onde linéaire, comprenant:

    -  une enceinte étanche (1) ;
    -  des moyens ($B_1$, $B_2$; $A_1$, $A_2$) pour créer un champ magnétique dans l'enceinte et générer une nappe de plasma (P);
    -  des moyens de couplage entre des moyens d'émission micro-onde et la nappe de plasma dans l'enceinte;
    -  au moins une cible (2), constituée d'au moins un élément à déposer, isolée électriquement de l'enceinte et portée à une tension de polarisation ($V_c$) par rapport à la nappe de plasma (P) ;
    -  des moyens de pompage (3) pour faire le vide dans l'enceinte (1) ;
    -  des moyens d'injection de gaz (9) pour le contrôle des espèces ioniques de la nappe de plasma (P) ;

    caractérisé en ce que :

- le champ magnétique possède un plan de symétrie confondu avec celui de la nappe de plasma (P) et celui de l'enceinte (1) ;
- le champ magnétique est constant dans la direction de la largeur de la nappe de plasma, ce qui permet d'obtenir la condition de résonance $2 \pi f_o = e\ B_{RES}\ /\ m$ sur toute la largeur de la nappe de plasma.

2. Appareil selon la revendication 1, caractérisé en ce que l'ensemble de la source est relié à la masse.

3. Appareil selon la revendication 1, caractérisée en ce que l'enceinte (1) a une forme parallélépipédique.

4. Appareil selon la revendication 1, caractérisée en ce que les moyens pour créer un champ magnétique comprennent des bobinages ($B_1$, $B_2$) entourant l'enceinte (1).

5. Appareil selon la revendication 4, caractérisée en ce que la longueur des bobinages ($B_1$, $B_2$) est supérieure à la longueur de l'enceinte (1) de manière à éliminer les effets de bord liés au retour du courant.

6. Appareil selon la revendication 1, caractérisée en ce que les moyens pour créer un champ magnétique comprennent des blocs aimants permanents ($A_1$, $A_2$) disposés de part et d'autre de l'enceinte (1).

7. Appareil selon la revendication 6, caractérisée en ce que les blocs aimants permanents ($A_1$, $A_2$) sont prolongés au-delà de l'enceinte (1) pour éviter les effets de bord.

8. Appareil selon la revendication 1, caractérisée en ce que les moyens de couplage comprennent des guides d'ondes identiques associés selon leur grand ou petit côté pour générer un plan d'onde perpendiculaire au champ magnétique et répartir la puissance micro-onde de manière uniforme sur la largeur de la nappe de plasma.

9. Appareil selon la revendication 1, caractérisée en ce que la fréquence du champ électromagnétique produit à l'intérieur de l'enceinte est située dans la plage 1 GHz - 10 GHz.

10. Appareil selon la revendication 8, caractérisée en ce que les guides d'ondes sont réalisés, au moins partiellement en un matériau qui est celui de la cible.

11. Appareil selon la revendication 1, caractérisée en ce qu'elle présente une configuration magnétique plane de type miroir comprenant deux ensembles de bobinages ($B_1$, $B_2$) identiques parcourus par des courants égaux ($I_1$, $I_2$) et de même sens, ou de deux blocs d'aimants ($A_1$, $A_2$) identiques évidés dans leur partie centrale, disposés de part et d'autre de l'enceinte (1), le champ magnétique présentant deux maxima $B_{MAX}$ et un minimum $B_{MIN}$ situé entre ces maxima, la condition $B_{MAX} > B_{RES} > B_{MIN}$ étant satisfaite sur toute la largeur de la nappe de plasma, $B_{RES}$ étant la valeur du champ magnétique pour laquelle la pulsation gyromagnétique de l'électron est égale à la pulsation de l'onde électromagnétique utilisée pour créer le plasma.

12. Appareil selon la revendication 1, caractérisé en ce qu'elle présente une configuration magnétique plane à "CUSP" dans laquelle les courants ($I_1$, $I_2$) qui parcourent les bobinages ($B_1$, $B_2$) ou le vecteur aimantation dans les blocs d'aimants ($A_1$, $A_2$) sont de signes opposés, les bobinages et les aimants étant dimensionnés pour satisfaire la condition $B_{x-MAX}$, $B_{yMAX} > B_{RES}$ sur toute la largeur de la nappe de plasma.

13. Appareil selon la revendication 1, caractérisé en ce qu'elle présente une configuration magnétique hybride générée par la superposition :

- d'un champ magnétique à miroir créé par deux bobinages ($B_1$, $B_2$) qui entourent l'enceinte (1) ;
- d'un champ magnétique transversal produit par deux blocs d'aimants permanents ($A_1$, $A_2$) disposés de part et d'autre de l'enceinte (1).

14. Appareil selon l'une quelconque des revendications 1 à 13, caractérisée en ce que la configuration magnétique génère dans le plasma une surface plane où la condition de résonance $|B| = B_{RES}$ est satisfaite en tous les points de cette surface.

15. Appareil selon la revendication 11, caractérisée en ce qu'elle est utilisée pour réaliser un revêtement de surface par pulvérisation.

16. Appareil selon la revendication 12, caractérisé en ce qu'elle est utilisée pour réaliser un dépôt de couches minces métalliques.

17. Appareil selon l'une quelconque des revendications 13 ou 14, caractérisée en ce qu'elle est utilisée pour réaliser de l'implantation et de l'assistance ionique.

**Patentansprüche**

1. Vorrichtung zur Flächenbehandlung mit Hilfe eines Teilchenflusses, erzeugt durch Beschießen eines Targets mit einem Plasmastrahl, umfassend:

- einen dichten Behälter (1);
- Einrichtungen ($B_1$, $B_2$; $A_1$, $A_2$) um in dem Behälter ein Magnetfeld zu schaffen und eine Plasmaschicht (P) zu erzeugen;
- Kopplungseinrichtungen zwischen Mikrowellen-Sendeeinrichtungen und der Plasmaschicht in dem Behälter;
- wenigstens ein Target (2), gebildet durch wenigstens ein abzuscheidendes Element, elektrisch isoliert von dem Behälter und bezüglich der Plasmaschicht (P) auf eine Vorspannung ($V_c$) gebracht;
- Pumpeinrichtungen (3), um in dem Behälter (1) Vakuum herzustellen;
- Einrichtungen (9) zur Einspeisung von Gas zur Kontrolle der Ionenarten der Plasmaschicht (P);

**dadurch gekennzeichnet:**

- daß das Magnetfeld eine Symmetrieebene besitzt, die zusammenfällt mit der der Plasmaschicht (P) und der des Behälters (1);
- daß das Magnetfeld konstant ist in Richtung der Breite der Plasmaschicht, was ermöglicht, die Resonanzbedingung $2\pi f_0 = eB_{res}/m$ über die gesamte Breite der Plasmaschicht herzustellen.

2. Vorrichtung nach Anspruch 1, dadurch gekennzeichnet, daß die gesamte Quelle an Masse gelegt ist.

3. Vorrichtung nach Anspruch 1, dadurch gekennzeichnet, daß der Behälter (1) eine parallelflache Form hat.

4. Vorrichtung nach Anspruch 1, dadurch gekennzeichnet, daß die Einrichtungen zum Erzeugen eines Magnetfelds Wicklungen ($B_1$, $B_2$) umfassen, die den Behälter (1) umgeben.

5. Vorrichtung nach Anspruch 4, dadurch gekennzeichnet, daß die Länge der Wicklungen ($B_1$, $B_2$) größer ist als die Länge des Behälters (1), um die mit dem Rückstrom verbundenen Randeffekte zu vermeiden.

6. Vorrichtung nach Anspruch 1, dadurch gekennzeichnet, daß die Einrichtungen zur Erzeugung eines Magnetfeldes Permanentmagnetblöcke ($A_1$, $A_2$) umfassen, angeordnet beiderseits des Behälters (1).

7. Vorrichtung nach Anspruch 6, dadurch gekennzeichnet, daß die Permanentmagnetblöcke ($A_1$, $A_2$) über den Behälter (1) hinaus verlängert sind, um die Randeffekte zu vermeiden.

8. Vorrichtung nach Anspruch 1, dadurch gekennzeichnet, daß die Kopplungseinrichtungen identische Wellenleiter umfassen, entsprechend ihrer Längsseite oder Schmal- bzw. Stirnseite zugeordnet, um eine zum Magnetfeld senkrechte Wellenebene zu erzeugen und die Mikrowellenleistung gleichmäßig über die Breite der Plasmaschicht zu verteilen.

9. Vorrichtung nach Anspruch 1, dadurch gekennzeichnet, daß die Frequenz des im Innern des Behälters erzeugten elektromagnetischen Feldes sich im Bereich 1 GHz-10 GHz befindet.

10. Vorrichtung nach Anspruch 8, dadurch gekennzeichnet, daß die Wellenleiter wenigstens teilweise aus einem Material hergestellt werden, welches das des Targets ist.

11. Vorrichtung nach Anspruch 1, dadurch gekennzeichnet, daß sie eine flache magnetische Konfiguration des Spiegeltyps aufweist, zwei identische Wicklungseinheiten ($B_1$, $B_2$) umfassend, durchflossen von Strömen ($I_1$, $I_2$) die gleich sind und die gleiche Richtung haben, oder zwei identische Magnetblöcke ($A_1$, $A_2$), ausgespart in ihrem Mittelteil, angeordnet beiderseits des Behälters (1), wobei das magnetische Feld zwei Maxima $B_{MAX}$ und ein zwischen diesen Maxima befindliches Minimum $B_{MIN}$ aufweist, die Bedingung $B_{MAX} > B_{RES} > B_{MIN}$ über die gesamte Breite der Plasmaschicht erfüllt wird, $B_{RES}$ der Wert des Magnetfeldes ist, für das die Zyklotronfrequenz des Elektrons bzw. die Elektronenzyklotronfrequenz gleich der für die Erzeugung des Plasmas benutzten Frequenz ist.

12. Vorrichtung nach Anspruch 1, dadurch gekennzeichnet, daß sie eine ebene bzw. flache magnetische "CUSP"-Konfiguration aufweist, bei der die Ströme ($I_1$, $I_2$), die die Wicklungen ($B_1$, $B_2$) durchlaufen, oder der Magnetisierungsvektor in den Magnetblöcken ($A_1$, $A_2$) entgegengesetzte Vorzeichen aufweisen, wobei die Spulen und die Magnete so dimensioniert sind, daß sie die Bedingung $B_{xMAX}$, $B_{yMAX} > B_{RES}$ über die gesamte Breite der Plasmaschicht erfüllen.

13. Vorrichtung nach Anspruch 1, dadurch gekennzeichnet, daß sie eine hybride magnetische Konfiguration aufweist, erzeugt durch die Überlagerung:

- eines Spiegel-Magnetfeldes, erzeugt durch zwei Wicklungen ($B_1$, $B_2$), die den Behälter (1) umgeben;
- eines quergerichteten Magnetfeldes, erzeugt durch zwei Permanentmagnetblöcke ($A_1$, $A_2$), angeordnet beiderseits des Behälters (1).

14. Vorrichtung nach einem der Ansprüche 1 bis 13, dadurch gekennzeichnet, daß die magnetische Konfiguration in dem Plasma eine ebene Fläche erzeugt, wo die Resonanzbedingung $|B| = B_{RES}$ in allen Punkten dieser Fläche erfüllt ist.

15. Vorrichtung nach Anspruch 11, dadurch gekennzeichnet, daß sie benutzt wird, um eine Oberflächenbeschichtung durch Zerstäubung bzw. Sputtern herzustellen.

16. Vorrichtung nach Anspruch 12, dadurch gekennzeichnet, daß sie benutzt wird zur Abscheidung metallischer Dünnschichten.

17. Vorrichtung nach einem der Ansprüche 13 oder 14, dadurch gekennzeichnet, daß sie benutzt wird für Implantation und Ionenunterstützung.

**Claims**

1. Apparatus for the treatment of a surface with the aid of a particle flux obtained as a result of the bombardment of a target by a plasma jet having a linear microwave source for the treatment of surfaces by plasma comprising:

   - a tight enclosure (1),
   - means ($B_1$, $B_2$; $A_1$, $A_2$) for producing a magnetic field in the enclosure and generating a plasma layer (P),
   - coupling means between the microwave emission means and the plasma layer in the enclosure,
   - at least one target (2) constituted by at least one element to be deposited, which is electrically insulated from the enclosure and raised to a bias voltage ($V_c$) relative to the plasma layer (P),
   - pumping means (3) for producing the vacuum in the enclosure (1),
   - gas injection means (9) for checking the ion species of the plasma iayer (P),

   characterized in that:

   - the magnetic field has a plane of symmetry coinciding with that of the plasma layer (P) and that of the enclosure (1),
   - the magnetic field is constant in the direction of the width of the plasma layer, which makes it possible to obtain the resonance condition $2\pi f_o = eB_{RES}/m$ over the entire plasma layer width.

2. Apparatus according to claim 1, characterized in that the complete source is connected to earth.

3. Apparatus according to claim 1, characterized in that the enclosure (1) is parallelepipedic.

4. Apparatus according to claim 1, characterized in that the means for producing a magnetic field comprise coils ($B_1$, $B_2$) surrounding the enclosure (1).

5. Apparatus according to claim 4, characterized in that the length of the coils ($B_1$, $B_2$) exceeds the length of the enclosure (1) so as to eliminate the edge effects linked with the return of the current.

6. Apparatus according to claim 1, characterized in that the means for producing a magnetic field comprise permanent magnet blocks ($A_1$, $A_2$) positioned on either side of the enclosure (1).

7. Apparatus according to claim 6, characterized in that the permanent magnet blocks ($A_1$, $A_2$) are extended beyond the enclosure (1) in order to prevent edge effects.

8. Apparatus according to claim 1, characterized in that the coupling means comprise identical wave guides associated along their large or small side in order to generate a wave plane perpendicular to the magnetic field and distribute the microwave power uniformly over the plasma layer width.

9. Apparatus according to claim 1, characterized in that the frequency of the electromagnetic field produced within the enclosure is in the range 1 to 10 GHz.

10. Apparatus according to claim 8, characterized in that the wave guides are at least partly made from the same material as the target.

11. Apparatus according to claim 1, characterized in that it has a mirror-type, planar magnetic configuration comprising two coil arrays ($B_1$, $B_2$) of an identical nature traversed by identical currents ($I_1$, $I_2$) flowing in the same direction, or two identical magnet blocks ($A_1$, $A_2$) hollowed out in their central portion and placed on either side of the enclosure (1), the magnetic field having two maxima $B_{MAX}$ and one minimum $B_{MIN}$ located between said maxima, the condition $B_{MAX} > B_{RES} > B_{MIN}$ being satisfied over the entire plasma layer width, $B_{RES}$ being the value of the magnetic field for which the cyclotron angular frequency of the electron is equal to the angular frequency of the electromagnetic wave used for producing the plasma.

12. Apparatus according to claim 1, characterized in that it has a cusp-type, planar magnetic configuration in which the currents ($I_1$, $I_2$) flowing through the coil ($B_1$, $B_2$) or the magnetization vector in the mag-

net blocks ($A_1$, $A_2$) have opposite signs, the coils and the magnets being dimensioned so as to satisfy the condition $B_{xMAX}$, $B_{yMAX} > B_{RES}$ over the entire plasma layer width.

13. Apparatus according to claim 1, characterized in that it has a hybrid magnetic configuration generated by superimposing a mirror magnetic field produced by the two coils ($B_1$, $B_2$) surrounding the enclosure (1) and a transverse magnetic field produced by two permanent magnet blocks ($A_1$, $A_2$) on either side of the enclosure (1).

14. Apparatus according to any one of the claims 1 to 13, characterized in that the magnetic configuration generates in the plasma a planar surface where the resonance condition $|B| = B_{RES}$ is satisfied at all points of said surface.

15. Apparatus according to claim 11, characterized in that it is used for producing a surface coating by sputtering.

16. Apparatus according to claim 12, characterized in that it is used for producing a deposit of thin metal films.

17. Apparatus according to either of the claims 13 and 14, characterized in that it is used for producing ion assistance and implantation.

FIG. 1 a

FIG. 1 b

FIG. 1 c

$Bx \ (Y=0)$

$BMAX$

$BRES$

$0$

$X$

## FIG. 2 a

5   7   6

$Y$

$0$   $X$

$A1$   N S W S N S

$9$

$15$

$10$

$11$

$12$

$13$

$P_{UHT}$

$A2$

$P$

N S N S N S

$8$

$V_C$

$2$

$4$

$3$

## FIG. 2 b

$Y$   $A1$

$0$   $Z$

$1$

$10$   $A2$

$11$

$12$

$13$

## FIG. 2 c

$P_{UHF}$   $P_{UHF}$

FIG. 2 D

FIG. 3 a

FIG. 3 b

FIG. 4

FIG. 5

FIG. 6

FIG. 9

FIG. 7a

FIG. 7b

FIG. 7c

EP 0 685 143 B1

FIG. 8 a

FIG. 8 b

FIG. 8 c

21